(19) Europäisches Patentamt
European Patent Office
Office européen des brevets

(11) **EP 2 819 305 B1**

(12) **EUROPEAN PATENT SPECIFICATION**

(45) Date of publication and mention
of the grant of the patent:
**21.10.2015 Bulletin 2015/43**

(51) Int Cl.:
***H03F 3/08*** (2006.01)

(21) Application number: **13174344.5**

(22) Date of filing: **28.06.2013**

(54) **Amplifier circuit for an opto-electric device, detector arrangement, and method to operate an amplifier circuit for an opto-electric device**

Verstärkerschaltung für optoelektrische Vorrichtung, Detektoranordnung und Verfahren zum Betrieb einer Verstärkerschaltung für eine optoelektrische Vorrichtung

Circuit amplificateur pour un dispositif opto-électrique, dispositif détecteur et procédé pour faire fonctionner un circuit amplificateur destiné à un dispositif opto-électrique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**31.12.2014 Bulletin 2015/01**

(73) Proprietor: **ams AG**
**8141 Unterpremstätten (AT)**

(72) Inventors:
• **Niederberger, Mark**
**8840 Einsiedeln (CH)**
• **Hollinger, Dominik**
**8716 Schmerikon (CH)**

• **Ehrensperger, Roger**
**8718 Schaenis (CH)**

(74) Representative: **Epping - Hermann - Fischer Patentanwaltsgesellschaft mbH Schloßschmidstraße 5 80639 München (DE)**

(56) References cited:
**EP-A1- 0 564 349      EP-A1- 2 273 466
EP-A2- 0 181 146      EP-A2- 1 881 600
WO-A1-2011/120757    GB-A- 2 105 543
JP-A- S5 812 413        US-A- 5 012 202
US-A1- 2005 128 006   US-B1- 6 404 281**

**Description**

This invention relates to an amplifier circuit for an opto-electric device, to a detector arrangement, and to a method to operate an amplifier circuit for an opto-electric device.

In opto-electric applications with photo diodes as receiver element the target signal is often superimposed on a large direct current (DC) signal. Typical applications of such kind are light barriers, e.g. optical proximity switches, infrared (IR) remote control and the like. In such applications large DC or low frequency components are caused by daylight or other light sources, e.g. light bulbs, energy saving lamps and so on. In order to reduce the required dynamic signal range of a signal processing circuit the DC or low frequency components have to be eliminated. The remaining signal is often very small and therefore the photodiode frontend circuit should have low noise characteristics.

One common photodiode frontend comprises a transimpedance amplifier (TIA) which uses a resistor for a DC current path and a capacitor, e.g. high pass filter, for separating the target signal from the DC and low frequency signal. The disadvantage of such a circuit is that for a large DC current range the resistor of the DC current path must be small which leads to high noise levels of the circuit as well as a demand for rather big capacitor size. For applications with low supply voltages the resistor must be even smaller. Active feedback loops have been proposed to overcome these limitations but are rather sensitive to noise. Examples for optical receiver circuits comprising active feedback loops are given in US 2005/0128006 and EP 0564349.

It is an object of the present invention to provide an amplifier circuit and method to operate an amplifier circuit which has better noise performance and reduced dynamic range requirement for signal processing.

This object is solved by the subject matter of the independent claims. Further embodiments are subject of dependent claims.

According to an aspect of the invention, an amplifier circuit for an opto-electric device comprises a detection path comprising a main amplifier having a first and second amplifier input and an amplifier output. A feedback path comprises an integrator and a bypass transistor. The integrator is connected to the amplifier output via an integrator input and comprises a level-shifter circuit in a negative feedback. The bypass transistor is connected to the level-shifter circuit via its control side and connected to the first amplifier input.

The amplifier circuit provides an output voltage as a function of a measurement current generated by a detector to be connected to the circuit via a detector terminal. The measurement current is a photocurrent if the connected detector is a photo detector, like a photodiode. The output voltage is fed back via the feedback path to account for different components like DC, low- and high frequency components. The integrator corresponds to a filter and has a characteristic filter constant. If implemented as a low-pass filter the filter constant is the cut-off frequency. The terms DC, low- and high frequency should be understood with respect to the filter constant. In particular, the integrator can be designed to filter only high frequency components and to pass DC and low frequency components. This way the feedback blocks high frequencies.

By means of the level-shifter circuit the integrator controls a level-shifted voltage. Depending on the level-shifted voltage the bypass transistor receives a control voltage and operates in response to this voltage. As a consequence the bypass transistor provides a feedback current at the first amplifier input which is proportional to the level-shifted voltage.

Thus, the integrator does not control the bypass transistor directly but it controls it indirectly via the level shifted voltage. That voltage is proportional to the feedback current and due to the filter characteristics of the integrator basically only includes DC and low frequency components. In fact, the integrator can have high DC gain and high DC current suppression, i.e. cancellation of the DC components in the measurement current. Generation of the level shifted voltage can be realised with low noise. Furthermore, the DC transconductance of the feedback path varies the DC current due to the DC current dependency of the transconductance of bypass transistor but the lower cut-off frequency of a total transfer function does not vary.

This leads to several advantages. The proposed circuit has an active DC feedback and is suited for integrated circuits. It can eliminate a large range of DC or low frequency signals while offering a good noise performance. For example, the dominant time constant in the feedback path can be rather low which allows for smaller chip area in integrated applications which require cut-off frequency in the range of a few tens of kHz and a high DC current suppression, i.e. DC current cancellation, in the transfer function. The required dominant RC time constant in the DC feedback path does not depend on the DC gain of the feedback path which maximizes DC suppression because the transconductance of the feedback is not linearized. In fact, a linearization circuit usually reduces the gain by a feedback circuit such as degeneration resistors etc.

Preferably, the main amplifier is an amplifier having at least one input terminal and a negative gain. Thus, the main amplifier does not necessarily have to be a differential amplifier.

According to another aspect of the invention, a transimpedance amplifier comprises the main amplifier and a feedback resistor in a negative feedback path connecting the first amplifier input to the amplifier output. The transimpedance amplifier converts the measurement current to the output voltage. The gain of the transimpedance amplifier is set by means of the feedback resistor in the negative feedback path.

According to another aspect of the invention, the integrator comprises an operational amplifier which further comprises a first input as amplifier input terminal. A first capacitor is connected to the first input and to the level shifter circuit. A first resistor is connected to the first input, to the integrator input and to the level shifter circuit.

The integrator receives the output voltage as input. It acts as a filter structure and filters out high frequency components in the output voltage. By means of the first capacitor and first resistor the integrator has low-pass filter characteristics. To first approximation the integrator can be characterized by a filter constant, e.g. a lower cut-off frequency. High and low frequencies are then determined with respect to the cut-off frequency. As a consequence of the integrator only DC and low frequency components pass.

According to another aspect of the invention, the level-shifter circuit comprises a second resistor connected to an analog ground potential. The level-shifted voltage drops across the second resistor. The integrator does not control the bypass transistor directly but it controls the level shifted voltage across the second resistor. That voltage is proportional to the feedback current and especially low in noise level due to the connection to analog ground potential which is a low noise node.

According to another aspect of the invention, the level-shifter circuit comprises a first current-mirror. The first current-mirror provides a first mirror ratio to adjust the control voltage at the bypass transistor.

According to another aspect of the invention, the first current-mirror comprises a first branch further comprising a series connection of the second resistor connected to a lower supply voltage via a first transistor. Both second resistor and first transistor are connected to the first capacitor. Furthermore, the first branch is connected in a current mirror fashion to a second branch. The second branch comprises a series connection of a second transistor and a third transistor and is connected between an upper supply voltage and the lower supply voltage. A control side of the third transistor is connected to the operational amplifier.

Due to the level shifted voltage across the second resistor there is a first current flowing through the first branch. The current mirror mirrors this first current into a second current as dictated by the first mirror ratio. The first mirror ratio in this embodiment is determined as second current over first current. The control voltage is set depending on this first mirror ratio.

According to another aspect of the invention, the feedback path comprises a second current mirror which comprises the third transistor and the bypass transistor. The second current mirror sets the feedback current based on a second mirror ratio which depends on the first mirror ratio due to the link via the shared third transistor. In fact, the second mirror ratio can be set to be the ratio of feedback current over second current. This way the feedback current depends not only on the level shifted voltage but shares its low noise level.

According to another aspect of the invention, the third transistor is connected to the upper supply terminal (VDD) via a third resistor, and/or the bypass transistor is connected to the upper supply terminal via a fourth resistor. Third and fourth resistors can be used to further reduce noise level in the feedback current.

According to another aspect of the invention, a first filter comprises the first resistor and a second capacitor connected in parallel to the first resistor and further connected to the integrator input. The noise performance can be even further improved by implementation of the additional filter.

According to another aspect of the invention, a second filter comprises a third capacitor and a fifth resistor connected as a low pass filter between the third transistor and the bypass transistor.

According to another aspect of the invention, a pole of the second filter is compensated by a zero of the transfer function of the first filter. The implementation of the second filter introduces an additional pole in the transfer function which is compensated by a zero to assure stability of the feedback. The filter resistances and capacitances can be adjusted with respect to each other for zero compensation.

According to another aspect of the invention, a detector arrangement comprises an amplifier circuit according to the principle discussed above. Furthermore, a photo detector, in particular, a photodiode, is connected to the amplifier input via a detector terminal.

According to another aspect of the invention, a method for operating an amplifier circuit for an opto-electric device, comprises the following steps. An output voltage is provided as a function of a measurement current. The output voltage is integrated using an integrator having a negative feedback path. A level-shifted voltage is controlled by the integrator by means of a level-shifter circuit which is implemented into the integrator's negative feedback path. The control depends on the integrated output voltage. Then, a bypass transistor is controlled by using a control voltage which depends on the level-shifted voltage. Finally, the measurement current is controlled with a feedback current being proportional to the level-shifted voltage.

Following the method the integrator does not control the bypass transistor directly but controls it indirectly via the level shifted voltage. That voltage is proportional to the feedback current and due to the filter characteristics of the integrator basically only includes DC and low frequency components. In fact, the integrator can have high DC gain and therefore high DC current suppression, i.e. cancellation of the DC components in the measurement current. Generation of the level shifted voltage can be realised with low noise. Furthermore, the DC transconductance of the feedback varies the DC current due to the DC current dependency of the transconductance of the bypass transistor but the lower cut-off frequency of a total transfer function does not vary.

This leads to several advantages. The proposed method implements an active DC feedback and is suited for integrated solutions. It can eliminate a large range of DC or low frequency signals while offering a good noise performance. For example, the dominant time constant in the feedback path can be rather low which allows for smaller chip area in integrated applications which require cut-off frequency in the range of a few tens of kHz and a high DC current suppression, i.e. DC current cancellation, in the transfer function. The required dominant RC time constant in the DC feedback does not depend on the DC gain which maximizes DC suppression because the transconductance of the feedback is not linearized. In fact, a linearization usually reduces the gain by a feedback circuit such as degeneration resistors etc.

According to another aspect of the invention, the compensating involves subtracting feedback current from the measurement current.

According to another aspect of the invention, the control voltage is adjusted using a first and second mirror ratio defined by the level-shifter circuit and the bypass transistor, respectively.

In the following, the principle presented above will be described in more detail with respect to drawings in which exemplary embodiments are presented.

Figure 1 shows an exemplary embodiment of an amplifier circuit according to the principle presented,

Figure 2 shows an exemplary frequency characteristic of an exemplary embodiment of an amplifier circuit according to the principle presented, and

Figure 3 shows another exemplary embodiment of an amplifier circuit according to the principle presented.

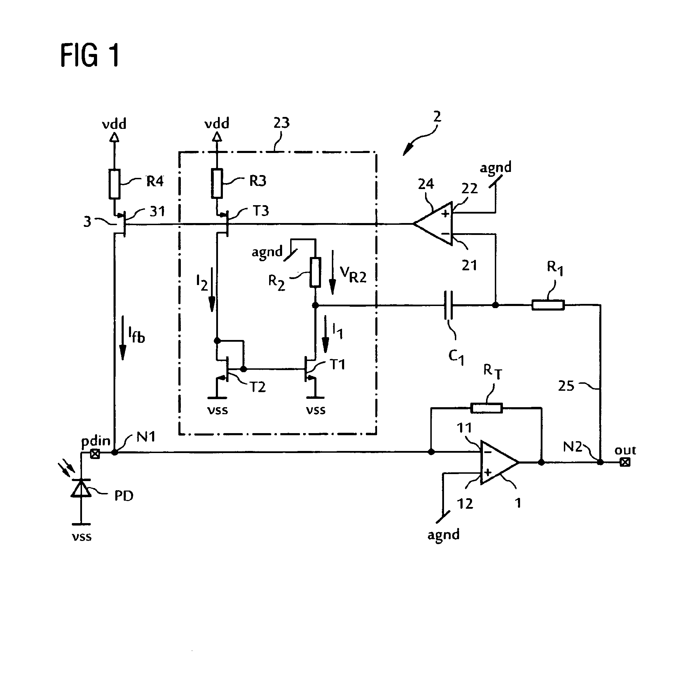

Figure 1 shows an exemplary embodiment of an amplifier circuit according to the principle presented. The amplifier circuit comprises a detection path and a feedback path. The detection path comprises first and second circuit nodes N1, N2 to connect to the feedback path. The amplifier circuit is connected to a photo element, in this particular embodiment a photodiode PD, which is connected to a lower supply voltage VSS in reverse direction.

The detection path connects a detector terminal pdin to an output terminal OUT via a main amplifier 1, which in this particular embodiment, is comprised by a transimpedance amplifier with a feedback resistor RT connecting an output and a first input 11 of the main amplifier 1. A second amplifier input 12 is connected to analog ground AGND.

The feedback path comprises an integrator 2 and a bypass transistor 3. The integrator comprises an operational transimpedance amplifier 24, having a first input 21 and a second input 22. The first input 21 is connected to the second circuit node N2 of the detection path via a first resistor R1. Furthermore, the first input 21 is connected to a first capacitor C1. The second input 22 is connected to analog ground AGND. A negative feedback path connects an output of the integrator amplifier and one plate of the first capacitor C1. This connection is established via a level shifter circuit 23.

The level shifter circuit 23 comprises a first and a second branch, wherein the first branch comprises a series connection of a second resistor R2 and a first transistor T1. The series connection is connected to analog ground AGND via the second resistor R2 and to a lower supply voltage VSS via the first transistor T1. Both second resistor R2 and first transistor T1 are connected to the first capacitor C1. The first branch is further connected in a current mirror fashion to the second branch. The second branch comprises a series connection of a second transistor T2, a third transistor T3 and optionally a third resistor R3. The second branch is connected between an upper supply voltage VDD and the lower supply voltage VSS. A control side of the third transistor T3 is connected to the operational amplifier 24 of the integrator 2.

The bypass transistor 3 is connected to the integrator 2 via the level shifter 23, in particular via the control side of the third transistor T3. The connection is established via the control side 31 of the bypass transistor 3. The bypass transistor 3 is connected in series between the upper supply voltage VDD, optionally a fourth resistor R4, to the first circuit node N1 of the detection path.

During operation of the amplifier the circuit is connected to the photodiode PD and ambient light or radiation induces a measurement current Ipd. In this particular embodiment the measurement current corresponds to a photocurrent. The photocurrent typically has several different components wherein the DC current and low frequency components are of no particular interest and are reduced or filtered from the output voltage Vout.

Basically, the detected photocurrent Ipd is first applied to the first amplifier input 11 of the main amplifier 1 which is a transimpedance amplifier designed to convert the photocurrent Ipd into the output voltage Vout depending on the resistance value of feedback resistor RT. The feedback path is designed to filter high frequency components from the output voltage Vout and generate a feedback current Ifb which only includes the DC components and low frequency components. When superimposed with the photocurrent Ipd in the detection path the resulting signal basically only includes higher frequency components.

In more detail the integrator 2 in the feedback path operates as a filter having a filter constant defined by the first resistor R1 and the first capacitor C1. As a consequence, high frequency components (with respect to the time constant of the integrator 2) are filtered and the integrated output voltage Vout only comprises low frequency components and DC components. The so integrated output voltage is induced into the level shifter circuit 23.

Depending on this induced voltage, the analog ground AGND level and the lower supply voltage VSS, a level shifted voltage VR2 drops across the second resistor R2. As a consequence, a first current flows I1 through the first transistor T1 and is mirrored into the second branch of level shifter 23 according to a first mirror ratio M1 = I2/I1. As a result, a second current I2 flows through the second branch of the level shifter circuit 23. This second current I2 is mirrored again according to a second mirror ratio M2=Ifb/I2 wherein Ifb is a feedback current. This gives rise to a control voltage VM2 applied to a control side 31 of the bypass transistor 3. The bypass transistor 3 operates in response to that control voltage and generates the feedback current Ifb flowing via the fourth resistor R4 through the bypass transistor 3. The feedback current Ifb only comprises DC- and low frequency components.

In conclusion, in the amplifier circuit the integrator 2 is used in the feedback path not to control the bypass transistor 3 directly but control the level shifted voltage VR2 across second resistor R2. Voltage VR2 is proportional to the feedback current Ifb. Due to rather high DC gain of the integrator 2 the amplifier circuit provides a high DC current suppression, i.e. cancellation of DC components in the photocurrent Ipd. The level shifter circuit 23 allows connecting the resistor to analog ground AGND which can be made a low noise node.

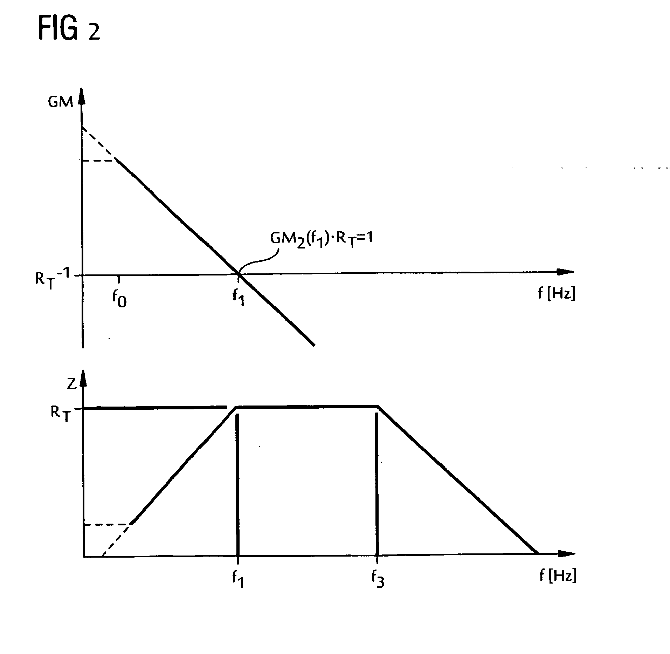

As will be discussed in more detail with respect to Figure 2 due to dependency of the feedback current Ifb on the bypass transistor 3, the DC transconductance of the feedback path varies the feedback current Ifb but a lower cut-off frequency f1 of a total transfer function of the amplifier circuit does not vary. This is because the lower cut-off frequency f1 depends only on resistor and capacitor values and mirror ratios but not on the DC transconductance of the feedback path.

Figure 2 shows an exemplary frequency characteristic of an exemplary embodiment of an amplifier circuit according to the principle presented. The drawing depicts two graphs: the upper one shows the transconductance GM of the feedback path as a function of frequency f; the lower graph shows the transfer function of the amplifier circuit as a function of frequency f. The DC transconductance GM is defined by the ratio of the current change at the first circuit node N1 to the voltage change at the second circuit node N2. Generally, the transconductance is a function of frequency GM = GM(f).

For the amplifier circuit of Figure 1 the transconductance of the feedback path corresponds to its DC gain and is given as

$$GM_{fbDC} = \frac{I_{fbDC}}{V_{outDC}} = A_{\text{int}\,DC} \cdot gm_{T4DC} \,,$$

with $GM_{fbDC}$: DC transconductance of the feedback path, $I_{fbDC}$: feedback current (DC only), $V_{outDC}$: output voltage (DC only), $A_{intDC}$: DC gain of integrator, and $gm_{T4DC}$: DC transconductance of the bypass transistor. Thus, the overall DC transconductance is determined by the DC gain of the integrator 2 and the transconductance of the bypass transistor 3. In fact, the DC transconductance $GM_{fbDC}$ of the feedback path varies with the feedback current Ifb.

The feedback transconductance, and consequently the output voltage Vout, depends on the frequency f of the photocurrent Ipd,. The integrator basically is a filter, in fact, a low-pass filter. Generally, a low-pass filter can be characterized by its cut-off frequency f0 which is given by

$$f0 = \frac{1}{2\pi \cdot C \cdot R} = \frac{1}{2\pi \cdot C1 \cdot R1} \,.$$

Integrator 2, however, in a certain sense is a modified low-pass filter. Thus, taking the bypass transistor T4 into account the resulting transconductance is given by

$$GM(s) = \frac{I_{fb}(s)}{Vout(s)} \frac{M1 \cdot M2}{R2} \cdot \frac{1}{sC_1 \cdot R_1} \,,$$

wherein s is a Laplace operator, *M1* and *M2* are the mirror ratios introduced above, and *R2* is the corresponding resistance value of the second resistor R2. Note, that the transfer function H2(s) of the integrator alone is determined by

$$H2(s) = \frac{VR2(s)}{Vout(s)} = \frac{1}{s \cdot C1 \cdot R1} \; .$$

Resistors R3, and R4 are not considered in this discussion. At the cut-off frequency f1 of the integrator 2 the transconductance is determined by

$$GM(f1) \cdot R_T = 1$$

if the total loop gain is set to one ($R_T$ is the resistance value of the feedback resistor RT).

From these considerations a transfer function $Z(s)$ can be derived. The transfer function of the amplifier circuit is shown in the lower graph. Due to the integrator 2 and the current mirrors in the level shifting circuit 23 of the feedback path the lower cut-off frequency f1 of the total transfer function is defined by the integrator time constant given by $R1 \cdot C1$, the mirror ratios M1 and M2 and the resistance of the second resistor R2. The total transfer function Z(s) can be calculated as:

$$Z(s) = \frac{R_2}{M_1 \cdot M_2} \cdot \frac{s \cdot R_1 \cdot C_1}{1 + s \cdot \dfrac{R_2}{M_1 \cdot M_2 \cdot R_T} \cdot R_1 \cdot C_1} \; .$$

The transfer function $Z(s)$ further defines the lower cut-off frequency to be

$$f1 = M1 \cdot M2 \cdot \frac{R_T}{R2} \cdot \frac{1}{2\pi \cdot C1 \cdot R1} \; .$$

From this result it is clear that the lower cut-off frequency f1 of the total transfer function does not vary with the feedback current Ifb as it depends only on resistor and capacitor values and mirror ratios but not on the DC transconductance of the feedback path. In other words, the lower cut-off frequency f1 is independent of DC suppression.

For example, set the DC current IDC,max in the photocurrent Ipd to 2mA, DC suppression to 1000, and lower cut-off frequency f1 to 10 kHz, and RT=100 k$\Omega$, R2=3,75 k$\Omega$, M1=0,25, M2=52,5. Then, the time constant of integrator 2 is $R1 \cdot C1$=5,57 ms. Thus, especially for large DC current ranges where a high DC attenuation (DC cancellation) is required the size of the first capacitor C1 and first resistor R1 can be kept rather low.

In summary, the amplifier circuit has several advantages. The dominant RC time constant in the DC feedback path can be set rather low. This leads to smaller chip area in integrated applications in which the lower cut-off frequency f1 is in the range of a few tens of kHz and a high DC current suppression (DC current cancellation) in the transfer function is required. The required dominant RC time constant in the DC feedback path does not depend on the DC gain of the feedback path and maximizes DC suppression because the transconductance of the feedback is not linearized. A linearization circuit usually reduces gain by a feedback circuit, e.g. degeneration resistor.

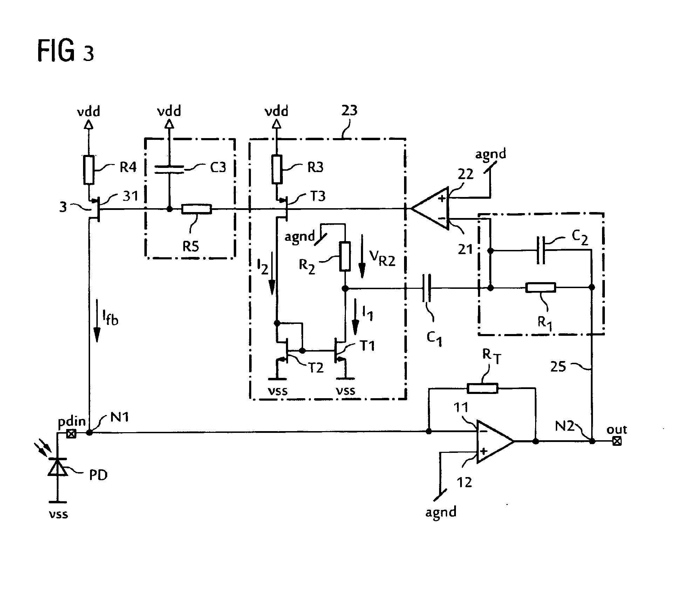

Figure 3 shows another exemplary embodiment of an amplifier circuit according to the principle presented. The amplifier circuit shown in the drawing corresponds to the one discussed with respect to Figure 1 except that two more filter structures are introduced to further improve the noise performance of the amplifier circuit.

In particular, a first additional filter comprises the first resistor R1 and a second capacitor C2 being connected in parallel to the first resistor R1 and further connected to the input 21. A second additional filter comprises a third capacitor C3 and fifth resistor R5 being connected as a low pass filter between third transistor T3 and bypass transistor 3.

Both additional filters can be used alone or together, as depicted in this embodiment. However, the implementation of the R5, C3 filter introduces an additional pole in the transfer function which should be compensated by a zero. The filter R1, C2 can be adjusted with respect to the R5, C3 filter for zero compensation.

Filter parameters, for example, cut-off frequency fc1, fc2, determine the respective transfer functions of the filters. The first and second additional filters are tuned to each other in such a manner that they jointly lead to a phase shift which maintains the feedback stability. Phase shifts used are preferably smaller than 180 degrees. Also preferred are phase shifts in a range from 120 degrees to 135 degrees. This can be implemented by selecting their cut-off frequencies fc1, fc2 and the associated resistors and capacitors R1, R5, C2, C3 in such a manner to ensure that the second filter R5, C3 has a pole and that this pole can be compensated by means of a zero point of the first filter R1, C2. Such zero-pole compensation is characterized by the following equation:

$$fc1 = \frac{1}{(2\pi \cdot R1 \cdot C2)} = \frac{1}{(2\pi \cdot R5 \cdot C3)} = fc2 \, ,$$

wherein fc2 denotes the cut-off frequency of the zero-pole compensation. When this equation is satisfied, an overall transfer function has a profile that an individual low-pass filter would have. This leads to the conclusion that a pole of the second filter R5, C3 has been compensated by a zero point of the first filter R1, C2.

The first and second filters are thus tuned to each other in such a manner that they jointly lead to an overall transfer function, which corresponds to a low-pass filter. The advantage is that this assures a phase shift that maintains the feedback stable. Phase shifts used are preferably smaller than 180 degrees. Also preferred are phase shifts in a range from 120 degrees to 135 degrees.

Reference numerals

| | |
|------|------|
| 1 | main amplifier |
| 11 | amplifier input |
| 12 | amplifier input |
| 13 | amplifier output |
| 2 | integrator |
| 21 | input |
| 22 | input |
| 23 | level-shifting circuit |
| 24 | operational amplifier |
| 25 | integrator input |
| 3, T4 | bypass transistor |
| 31 | control side of bypass transistor |
| AGND | analog ground |
| C1 | capacitor |
| C2 | capacitor |
| C3 | capacitor |
| f0 | cut-off frequency |
| f1 | cut-off frequency |
| f2 | cut-off frequency |
| I1 | first current |
| I2 | second current |
| Ifb | feedback current |
| N1 | circuit node |
| N2 | circuit node |
| OUT | output terminal |
| PD | photodiode |
| pdin | detector terminal |
| R1 | resistor |
| R2 | resistor |
| R3 | resistor |
| R4 | resistor |
| R5 | resistor |
| RT | feedback resistor |
| T1 | transistor |
| T2 | transistor |
| T3 | transistor |
| VDD | upper supply voltage |
| VOUT | output voltage |
| VR2 | level-shifted voltage |

VSS    lower supply voltage

**Claims**

1. Amplifier circuit for an opto-electric device, comprising:

   - a detection path comprising a main amplifier (1) for providing an output voltage (Vout) as a function of a measurement current (Ipd) having a first and second amplifier input (11, 12) and an amplifier output (13),
   - a feedback path comprising an integrator (2) and a bypass transistor (3),
   - the integrator (2) being connected to the amplifier output (13) via an integrator input (25) and comprising a level-shifter circuit (23) in a negative feedback path for controlling a level-shifted voltage (VR2), and
   - the bypass transistor (3) being connected to the level-shifter circuit (23) via its control side (31) to receive a control voltage depending on the level-shifted voltage (VR2), and providing a feedback current (Ifb) at the first amplifier input (11) being proportional to the level-shifted voltage (VR2).

2. Amplifier circuit according to claim 1, wherein the main amplifier (1) is comprised by a transimpedance amplifier having a feedback resistor (RT) in a negative feedback path connecting the first amplifier input (11) to the amplifier output (13).

3. Amplifier circuit according to claim 1 or 2, wherein the integrator (2) comprises

   - an operational amplifier (24) further comprising a first input (21),
   - a first capacitor (C1) connected to the first input (21) and to the level shifter circuit (23), and
   - a first resistor (R1) connected to the integrator input (25), to the first input (21) and to the first capacitor (C1).

4. Amplifier circuit according to one of claims 1 to 3, wherein the level-shifter circuit (23) comprises a second resistor (R2) connected to an analog ground potential (AGND) and wherein the level-shifted voltage (VR2) drops across the second resistor (R2).

5. Amplifier circuit according to one of claims 1 to 4, wherein the level-shifter circuit (23) comprises a first current-mirror.

6. Amplifier circuit according to one of claims 1 to 5, wherein the first current-mirror comprises

   - a first branch further comprising a series connection of the second resistor (R2) connected to a lower supply voltage (VSS) via a first transistor (T1), both second resistor (R2) and first transistor (T1) being connected to the first capacitor (C1), and the first branch connected in a current mirror fashion to a second branch, and
   - the second branch further comprising a series connection of a second transistor (T2) and a third transistor (T3) connected between an upper supply voltage (VDD) and the lower supply voltage (VSS), wherein a control side of the third transistor (T3) is connected to the operational amplifier (24).

7. Amplifier circuit according to one of claims 1 to 6, wherein the feedback path comprises a second current mirror further comprising the third transistor (T3) and the bypass transistor (3).

8. Amplifier circuit according to one of claims 1 to 7, wherein

   - the third transistor (T3) is connected to the upper supply terminal (VDD) via a third resistor (R3), and/or
   - the bypass transistor (3) is connected to the upper supply terminal (VDD) via a fourth resistor (R4).

9. Amplifier circuit according to one of claims 1 to 8, wherein a first filter comprises the first resistor (R1) and a second capacitor (C2) being connected in parallel to the first resistor (R1) and further connected to the first input (21).

10. Amplifier circuit according to one of claims 1 to 9, wherein a second filter comprises a third capacitor (C3) and a fifth resistor (R5) being connected as a low pass filter between the third transistor (T3) and the bypass transistor (3).

**11.** Amplifier circuit according to claim 10, wherein a pole of the second filter (R5, C3) is compensated by a zero point of the first filter (R1, C2).

**12.** Detector arrangement, comprising

- an amplifier circuit according to one of claims 1 to 11, and
- a photo detector (PD), in particular, a photodiode connected to the amplifier input (11) via a detector terminal (pdin).

**13.** Method for operating an amplifier circuit for an opto-electric device, comprising the steps of:

- providing an output voltage (Vout) as a function of a measurement current (Ipd),
- integrating the output voltage (Vout) using an integrator (2) comprising a negative feedback path,
- controlling a level-shifted voltage (VR2) by means of a level-shifter circuit (23) in the integrator's (2) negative feedback path depending on the integrated output voltage (Vout),
- controlling a bypass transistor (3) using a control voltage depending on the level-shifted voltage (VR2), and
- compensating the measurement current (Ipd) with a feedback current (Ifb) being proportional to the level-shifted voltage (VR2).

**14.** Method according to claim 13, wherein the compensating involves subtracting feedback current (Ifb) from the measurement current (Ipd).

**15.** Method according to claim 13 or 14, wherein the control voltage is adjusted using a first and second mirror ratio defined by the level-shifter circuit (23) and the bypass transistor (3), respectively.

**Patentansprüche**

**1.** Verstärkerschaltung für eine optoelektrische Vorrichtung, Folgendes aufweisend:

- einen Detektionspfad, der einen Hauptverstärker (1) umfasst, um in Abhängigkeit von einem Messstrom (Ipd) eine Ausgangsspannung (Vout) bereitzustellen, der einen ersten und zweiten Verstärkereingang (11, 12) und einen Verstärkerausgang (13) aufweist,
- einen Rückkopplungspfad, der einen Integrator (2) und einen Umgehungstransistor (3) umfasst,
- wobei der Integrator (2) über einen Integratoreingang (25) an den Verstärkerausgang (13) angeschlossen ist und eine Pegelumsetzerschaltung (23) in einem Negativrückkopplungspfad umfasst, um eine pegelumgesetzte Spannung (VR2) zu regeln, und
- wobei der Umgehungstransistor (3) über seine Regelseite (31) an die Pegelumsetzerschaltung (23) angeschlossen ist, um eine von der pegelumgesetzten Spannung (VR2) abhängige Regelspannung zu empfangen und einen Rückkopplungsstrom (Ifb) am ersten Verstärkereingang (11) bereitzustellen, der proportional zur pegelumgesetzten Spannung (VR2) ist.

**2.** Verstärkerschaltung nach Anspruch 1, wobei der Hauptverstärker (1) aus einem Transimpedanzverstärker besteht, der einen Rückkopplungswiderstand (RT) in einem Negativrückkopplungspfad aufweist, der den ersten Verstärkereingang (11) mit dem Verstärkerausgang (13) verbindet.

**3.** Verstärkerschaltung nach Anspruch 1 oder 2, wobei der Integrator (2) umfasst:

- einen Operationsverstärker (24), der darüber hinaus einen ersten Eingang (21) umfasst,
- einen ersten Kondensator (C1), der an den ersten Eingang (21) und an die Pegelumsetzerschaltung (23) angeschlossen ist, und
- einen ersten Widerstand (R1), der an den Integratoreingang (25), den ersten Eingang (21) und den ersten Kondensator (C1) angeschlossen ist.

**4.** Verstärkerschaltung nach einem der Ansprüche 1 bis 3, wobei die Pegelumsetzerschaltung (23) einen zweiten Widerstand (R2) umfasst, der an ein analoges Massepotential (AGND) angeschlossen ist, und wobei die pegelumgesetzte Spannung (VR2) am zweiten Widerstand (R2) abfällt.

**5.** Verstärkerschaltung nach einem der Ansprüche 1 bis 4, wobei die Pegelumsetzerschaltung (23) einen ersten Stromspiegel umfasst.

**6.** Verstärkerschaltung nach einem der Ansprüche 1 bis 5, wobei der erste Stromspiegel umfasst:

- einen ersten Zweig, der darüber hinaus eine Reihenschaltung aus dem zweiten Transistor (R2) umfasst, der über einen ersten Transistor (T1) an eine untere Versorgungsspannung (VSS) angeschlossen ist, wobei sowohl der zweite Widerstand (R2) als auch der erste Transistor (T1) an den ersten Kondensator (C1) angeschlossen ist, und der erste Zweig nach Art eines Stromspiegels an einen zweiten Zweig angeschlossen ist, und
- wobei der zweite Zweig darüber hinaus eine Reihenschaltung aus einem zweiten Transistor (T2) und einem dritten Transistor (T3) umfasst, die zwischen einer oberen Versorgungsspannung (VDD) und der unteren Versorgungsspannung (VSS) angeschlossen sind, wobei eine Regelseite des dritten Transistors (T3) an den Operationsverstärker (24) angeschlossen ist.

**7.** Verstärkerschaltung nach einem der Ansprüche 1 bis 6, wobei der Rückkopplungspfad einen zweiten Stromspiegel umfasst, der darüber hinaus den dritten Transistor (T3) und den Umgehungstransistor (3) umfasst.

**8.** Verstärkerschaltung nach einem der Ansprüche 1 bis 7, wobei

- der dritte Transistor (T3) über einen dritten Widerstand (R3) an den oberen Versorgungsanschluss (VDD) angeschlossen ist, und/oder
- der Umgehungstransistor (3) über einen vierten Widerstand (R4) an den oberen Versorgungsanschluss (VDD) angeschlossen ist.

**9.** Verstärkerschaltung nach einem der Ansprüche 1 bis 8, wobei ein erstes Filter den ersten Widerstand (R1) und einen zweiten Kondensator (C2) umfasst, der mit dem ersten Widerstand (R1) parallelgeschaltet und darüber hinaus an den ersten Eingang (21) angeschlossen ist.

**10.** Verstärkerschaltung nach einem der Ansprüche 1 bis 9, wobei ein zweites Filter einen dritten Kondensator (C3) und einen fünften Widerstand (R5) umfasst, die als Tiefpassfilter zwischen dem dritten Transistor (T3) und dem Umgehungstransistor (3) angeschlossen sind.

**11.** Verstärkerschaltung nach Anspruch 10, wobei ein Pol des zweiten Filters (R5, C3) durch eine Nullstelle des ersten Filters (R1, C2) kompensiert ist.

**12.** Detektoranordnung, Folgendes umfassend:

- eine Verstärkerschaltung nach einem der Ansprüche 1 bis 11, und
- einen Photodetektor (PD), insbesondere eine Photodiode, die über einen Detektoranschluss (pdin) an den Verstäkrereingang (11) angeschlossen ist.

**13.** Verfahren zum Betreiben einer Verstärkerschaltung für eine optoelektrische Vorrichtung, die folgenden Schritte umfassend:

- Bereitstellen einer Ausgangsspannung (Vout) in Abhängigkeit von einem Messstrom (Ipd),
- Integrieren der Ausgangsspannung (Vout) anhand eines Integrators (2), der einen Negativrückkopplungspfad umfasst,
- Regeln einer pegelumgesetzten Spannung (VR2) mittels einer Pegelumsetzerschaltung (23) im Negativrückkopplungspfad des Integrators (2) in Abhängigkeit von der integrierten Ausgangsspannung (Vout),
- Regeln eines Umgehungstransistors (3) anhand einer Regelspannung in Abhängigkeit von der pegelumgesetzten Spannung (VR2), und
- Kompensieren des Messstroms (Ipd) mit einem Rückkopplungsstrom (Ifb), der proportional zur pegelumgesetzten Spannung (VR2) ist.

**14.** Verfahren nach Anspruch 13, wobei das Kompensieren mit einem Subtrahieren des Rückkopplungsstroms (Ifb) vom Messstrom (Ipd) einhergeht.

**15.** Verfahren nach Anspruch 13 oder 14, wobei die Regelspannung anhand eines ersten und zweiten Spiegelverhältnisses eingestellt wird, das durch die Pegelumsetzerschaltung (23) bzw. den Umgehungstransistor (3) definiert ist.

**Revendications**

1. Circuit amplificateur pour un appareil optoélectrique, comprenant:

   - un trajet de détection comprenant un amplificateur principal (1) destiné à fournir une tension de sortie (Vout) en tant que fonction d'un courant de mesure (Ipd), présentant une première et une deuxième entrée d'amplificateur (11, 12) et une sortie d'amplificateur (13),
   - un trajet de réaction comprenant un intégrateur (2) et un transistor de dérivation (3),
   - l'intégrateur (2) étant connecté à la sortie d'amplificateur (13) via une entrée d'intégrateur (25) et comprenant un circuit décaleur de niveau (23) dans un trajet de réaction négatif pour commander une tension décalée en niveau (VR2), et
   - le transistor de dérivation (3) étant connecté au circuit décaleur de niveau (23) via son côté commande (31) pour recevoir une tension de commande en fonction de la tension décalée en niveau (VR2), et fournissant, au niveau de la première entrée d'amplificateur (11), un courant de réaction (Ifb) qui est proportionnel à la tension décalée en niveau (VR2).

2. Circuit amplificateur selon la revendication 1, dans lequel l'amplificateur principal (1) est compris par un amplificateur à transimpédance comportant une résistance à réaction (RT) dans un trajet de réaction négatif connectant la première entrée d'amplificateur (11) à la sortie d'amplificateur (13).

3. Circuit amplificateur selon la revendication 1 ou 2, dans lequel l'intégrateur (2) comprend

   - un amplificateur opérationnel (24) comprenant en outre une première entrée (21),
   - un premier condensateur (C1) connecté à la première entrée (21) et au circuit décaleur de niveau (23), et
   - une première résistance (R1) connectée à l'entrée d'intégrateur (25), à la première entrée (21) et au premier condensateur (C1).

4. Circuit amplificateur selon l'une des revendications 1 à 3, dans lequel le circuit décaleur de niveau (23) comprend une deuxième résistance (R2) connectée à un potentiel de masse analogique (AGND) et dans lequel la tension décalée en niveau (VR2) baisse en passant dans la deuxième résistance (R2).

5. Circuit amplificateur selon l'une des revendications 1 à 4, dans lequel le circuit décaleur de niveau (23) comprend un premier miroir de courant.

6. Circuit amplificateur selon l'une des revendications 1 à 5, dans lequel le premier miroir de courant comprend

   - un premier embranchement comprenant en outre une connexion en série de la deuxième résistance (R2) connectée à une tension d'alimentation inférieure (VSS) via un premier transistor (T1), la deuxième résistance (R2) et le premier transistor (T1) étant tous deux connectés au premier condensateur (C1), et le premier embranchement étant connecté à la façon d'un miroir de courant à un deuxième embranchement, et
   - le deuxième embranchement comprenant en outre une connexion en série d'un deuxième transistor (T2) et d'un troisième transistor (T3) connectés entre une tension d'alimentation supérieure (VDD) et la tension d'alimentation inférieure (VSS), sachant qu'un côté commande du troisième transistor (T3) est connecté à l'amplificateur opérationnel (24).

7. Circuit amplificateur selon l'une des revendications 1 à 6, dans lequel le trajet de réaction comprend un deuxième miroir de courant comprenant en outre le troisième transistor (T3) et le transistor de dérivation (3).

8. Circuit amplificateur selon l'une des revendications 1 à 7, dans lequel

   - le troisième transistor (T3) est connecté à la borne d'alimentation supérieure (VDD) via une troisième résistance (R3), et/ou
   - le transistor de dérivation (3) est connecté à la borne d'alimentation supérieure (VDD) via une quatrième résistance (R4).

**9.** Circuit amplificateur selon l'une des revendications 1 à 8, dans lequel un premier filtre comprend la première résistance (R1) et un deuxième condensateur (C2) qui est connecté en parallèle à la première résistance (R1) et qui est en outre connecté à la première entrée (21).

**10.** Circuit amplificateur selon l'une des revendications 1 à 9, dans lequel un deuxième filtre comprend un troisième condensateur (C3) et une cinquième résistance (R5), qui sont connectés comme filtre passe-bas entre le troisième transistor (T3) et le transistor de dérivation (3).

**11.** Circuit amplificateur selon la revendication 10, dans lequel un pôle du deuxième filtre (R5, C3) est compensé par un point zéro du premier filtre (R1, C2).

**12.** Agencement de détecteur, comprenant

   - un circuit amplificateur selon l'une des revendications 1 à 11, et
   - un photodétecteur (PD), en particulier une photodiode, connecté à l'entrée d'amplificateur (11) via une borne de détecteur (pdin).

**13.** Procédé de fonctionnement d'un circuit amplificateur pour un appareil optoélectrique, comprenant les étapes consistant à:

   - fournir une tension de sortie (Vout) en tant que fonction d'un courant de mesure (Ipd),
   - intégrer la tension de sortie (Vout) à l'aide d'un intégrateur (2) comprenant un trajet de réaction négatif,
   - commander une tension décalée en niveau (VR2) au moyen d'un circuit décaleur de niveau (23) dans le trajet de réaction négatif de l'intégrateur (2) en fonction de la tension de sortie intégrée (Vout),
   - commander un transistor de dérivation (3) à l'aide d'une tension de commande en fonction de la tension décalée en niveau (VR2), et
   - compenser le courant de mesure (Ipd) avec un courant de réaction (Ifb) qui est proportionnel à la tension décalée en niveau (VR2).

**14.** Procédé selon la revendication 13, dans lequel la compensation implique de soustraire le courant de réaction (Ifb) du courant de mesure (Ipd).

**15.** Procédé selon la revendication 13 ou 14, dans lequel la tension de commande est réglée à l'aide d'un premier et d'un deuxième rapport de miroir définis par le circuit décaleur de niveau (23) et le transistor de dérivation (3), respectivement.

FIG 1

# FIG 2

# FIG 3

**EP 2 819 305 B1**

**REFERENCES CITED IN THE DESCRIPTION**

**Patent documents cited in the description**

- US 20050128006 A

- EP 0564349 A